# EUROPÄISCHE PATENTSCHRIFT

(11) **EP 2 005 542 B1**
(45) Veröffentlichungstag und Bekanntmachung des Hinweises auf die Patenterteilung: **18.12.2013**
(21) Anmeldenummer: 07722046.5
(22) Anmeldetag: 15.03.2007
(51) Int. Cl.: H01S 5/183, H01S 5/04, H01S 5/026, H01S 5/14, H01S 3/108

(54) **OPTOELEKTRONISCHES HALBLEITERBAUELEMENT**
OPTOELECTRONIC SEMICONDUCTOR ELEMENT
COMPOSANT SEMI-CONDUCTEUR OPTOÉLECTRONIQUE

(30) Priorität: 13.04.2006 DE 102006017572; 23.05.2006 DE 102006024220
(43) Veröffentlichungstag der Anmeldung: 24.12.2008
(73) Patentinhaber: OSRAM Opto Semiconductors GmbH, 93055 Regensburg (DE)
(72) Erfinder: LUTGEN, Stephan, 01309 Dresden (DE); BRICK, Peter, 93051 Regensburg (DE); ALBRECHT, Tony, 93077 Bad Abbach (DE)
(74) Vertreter: Epping, Wilhelm
(86) Internationale Anmeldenummer: PCT/DE2007/000473
(87) Internationale Veröffentlichungsnummer: WO 2007/118440

(56) Entgegenhaltungen:
- EP-A- 0 821 451
- EP-A- 1 605 562
- DE-A1- 19 947 853
- DE-A1-102004 004 781
- DE-A1-102004 042 146
- US-A- 5 796 771
- US-A1- 2002 075 929
- US-A1- 2002 146 053
- US-B1- 6 556 610

## Beschreibung

Es wird ein optoelektronisches Halbleiterbauelement angegeben.

Diese Patentanmeldung beansprucht die Priorität der deutschen Patentanmeldung 102006017572.7 und der deutschen Patentanmeldung 102006024220.3.

Die Druckschrift WO 2005/048424A1 beschreibt ein optoelektronisches Halbleiterbauelement.

Die Druckschrift EP 1 605 562 A2 beschreibt ein optoelektronisches Halbleiterbauelement gemäß dem Oberbegriff des Patentanspruchs 1.

Eine zu lösende Aufgabe besteht darin, ein optoelektronisches Halbleiterbauelement anzugeben, bei dem im Betrieb erzeugte Wärme besonders effizient an die Umgebung abgegeben werden kann.

Die Erfindung betrifft ein optoelektronisches Halbleiterbauelement gemäß Patentanspruch 1.

Gemäß zumindest einer Ausführungsform des optoelektronischen Halbleiterbauelements umfasst das Halbleiterbauelement einen Halbleiterkörper. Vorzugsweise ist der Halbleiterkörper epitaktisch auf ein Aufwachssubstrat abgeschieden.

Gemäß zumindest einer Ausführungsform des Halbleiterbauelements weist der Halbleiterkörper einen Vertikalemitterbereich auf. Der Vertikalemitterbereich umfasst eine Vertikalemitterschicht. Die Vertikalemitterschicht bildet den aktiven Bereich des Vertikalemitterbereichs. Die Vertikalemitterschicht ist zur Erzeugung elektromagnetischer Strahlung vorgesehen. Das heißt, die Vertikalemitterschicht erzeugt im Betrieb des Halbleiterbauelements ein elektromagnetisches Strahlungsfeld. Die Vertikalemitterschicht umfasst dazu vorzugsweise eine Quantentopfstruktur, besonders bevorzugt eine Mehrfachquantentopfstruktur. Die Bezeichnung Quantentopfstruktur umfasst dabei jegliche Struktur, bei der Ladungsträger durch Einschluss ("Confinement") eine Quantisierung ihrer Energiezustände erfahren können. Insbesondere beinhaltet die Bezeichnung Quantentopfstruktur keine Angaben über die Dimensionalität der Quantisierung. Sie umfasst somit unter anderem Quantentröge, Quantendrähte und Quantenpunkte und jede Kombination dieser Strukturen.

Gemäß zumindest einer Ausführungsform des optoelektronischen Halbleiterbauelements umfasst der Halbleiterkörper zumindest eine Pumpquelle. Die Pumpquelle ist zum optischen Pumpen der Vertikalemitterschicht vorgesehen. Vorzugsweise ist die Pumpquelle monolithisch in den Halbleiterkörper integriert. Monolithisch integriert bedeutet, dass die Pumpquelle mit dem Vertikalemitterbereich in einem gemeinsamen Wachstumsprozess epitaktisch gewachsen ist. Das heißt, der Halbleiterkörper umfasst den epitaktisch gewachsenen Vertikalemitterbereich sowie die epitaktisch gewachsene Pumpquelle.

Gemäß zumindest einer Ausführungsform weist der Halbleiterkörper eine Strahlungsdurchtrittsfläche auf. Zumindest ein Teil der im Vertikalemitterbereich erzeugten elektromagnetischen Strahlung verlässt den Halbleiterkörper durch die Strahlungsdurchtrittsfläche. Die Strahlungsdurchtrittsfläche ist beispielsweise durch zumindest einen Teil einer Hauptfläche des Halbleiterkörpers gebildet, die vorzugsweise quer zur Wachstumsrichtung des Halbleiterkörpers verläuft. Beispielsweise steht die Wachstumsrichtung auf der Hauptfläche senkrecht.

Gemäß zumindest einer Ausführungsform des Halbleiterbauelements sind die Pumpquelle und die Vertikalemitterschicht vertikal voneinander beabstandet. Das heißt mit anderen Worten, die Pumpquelle ist der Vertikalemitterschicht vertikal vor- und/oder nachgeordnet.

Gemäß zumindest einer Ausführungsform des optoelektronischen Halbleiterbauelements umfasst das Halbleiterbauelement einen Halbleiterkörper. Der Halbleiterkörper weist einen oberflächenemittierenden Vertikalemitterbereich auf, der eine Vertikalemitterschicht umfasst. Ferner weist der Halbleiterkörper zumindest eine Pumpquelle auf, die zum optischen Pumpen der Vertikalemitterschicht vorgesehen ist. Weiter weist der Halbleiterkörper eine Strahlungsdurchtrittsfläche auf, durch die in der Vertikalemitterschicht erzeugte elektromagnetische Strahlung den Halbleiterkörper verlässt, wobei die Pumpquelle und die Vertikalemitterschicht in vertikaler Richtung voneinander beabstandet sind.

Gemäß zumindest einer Ausführungsform des Halbleiterbauelements ist die Pumpquelle zwischen der Vertikalemitterschicht und der Strahlungsdurchtrittsfläche angeordnet. Das heißt mit anderen Worten, die Pumpquelle ist der Vertikalemitterschicht vertikal vor- oder nachgeordnet, wobei die Strahlungsdurchtrittsfläche des Halbleiterkörpers auf der der Vertikalemitterschicht abgewandten Seite der Pumpquelle angeordnet ist. Beispielsweise folgt die Pumpquelle der Strahlungsdurchtrittsfläche in der Wachstumsrichtung des Halbleiterkörpers nach. Die Vertikalemitterschicht folgt dann in der Wachstumsrichtung des Halbleiterkörpers der Pumpquelle nach.

Gemäß zumindest einer Ausführungsform des optoelektronischen Halbleiterbauelements umfasst das Halbleiterbauelement einen Halbleiterkörper. Der Halbleiterkörper weist einen oberflächenemittierenden Vertikalemitterbereich auf, der eine Vertikalemitterschicht umfasst. Ferner weist der Halbleiterkörper zumindest eine Pumpquelle auf, die zum optischen Pumpen der Vertikalemitterschicht vorgesehen ist. Weiter weist der Halbleiterkörper eine Strahlungsdurchtrittsfläche auf, durch die in der Vertikalemitterschicht erzeugte elektromagnetische Strahlung den Halbleiterkörper verlässt, wobei die Pumpquelle zwischen der Vertikalemitterschicht und der Strahlungsdurchtrittsfläche des Halbleiterkörpers angeordnet ist.

Gemäß zumindest einer Ausführungsform des Halbleiterbauelements ist die Vertikalemitterschicht zwischen der Pumpquelle und der Strahlungsdurchtrittsfläche angeordnet. Das heißt mit anderen Worten, die Vertikalemitterschicht ist der Pumpquelle vertikal vor- oder nachgeordnet, wobei die Strahlungsdurchtrittsfläche des Halbleiterkörpers auf der der Pumpquelle abgewandten Seite der Vertikalemitterschicht angeordnet ist. Beispielsweise folgt die Vertikalemitterschicht der Pumpquelle in der Wachstumsrichtung des Halbleiterkörpers nach. Die Strahlungsdurchtrittsfläche folgt dann in der Wachstumsrichtung des Halbleiterkörpers der Vertikalemitterschicht nach.

Gemäß zumindest einer Ausführungsform des optoelektronischen Halbleiterbauelements umfasst das Halbleiterbauelement einen Halbleiterkörper. Der Halbleiterkörper weist einen oberflächenemittierenden Vertikalemitterbereich auf, der eine Vertikalemitterschicht umfasst. Ferner weist der Halbleiterkörper zumindest eine Pumpquelle auf, die zum optischen Pumpen der Vertikalemitterschicht vorgesehen ist. Weiter weist der Halbleiterkörper eine Strahlungsdurchtrittsfläche auf, durch die in der Vertikalemitterschicht erzeugte elektromagnetische Strahlung den Halbleiterkörper verlässt, wobei die Vertikalemitterschicht zwischen der Pumpquelle und der Strahlungsdurchtrittsfläche des Halbleiterkörpers angeordnet ist.

Dem hier beschriebenen optoelektronischen Halbleiterbauelement liegt unter anderem die folgende Erkenntnis zugrunde: Zum Einen können durch die beschriebene Anordnung von Vertikalemitterschicht, Pumpquelle und Strahlungsdurchtrittsfläche im Halbleiterkörper Vertikalemitterschicht und Pumpquelle als vertikal voneinander beabstandete - beispielsweise epitaktisch nacheinander aufgewachsene - Schichtfolgen ausgeführt werden. Ein solcher Aufbau ermöglicht eine Vielzahl von Möglichkeiten bezüglich der Wahl der Materialien und der Dimensionierung der Bereiche des Halbleiterkörpers. Dadurch kann beispielsweise die Wellenlänge der Pumpstrahlung zum optischen Pumpen der Vertikalemitterschicht und/oder die Wellenlänge der von der Vertikalemitterschicht vertikal emittierten Strahlung innerhalb weiter Grenzen eingestellt werden.

Ferner ermöglicht der beschriebene Aufbau, dass der Halbleiterkörper mit der Seite, auf der sich der Vertikalemitterbereich befindet, an einen Wärmeleitkörper - beispielsweise einen Träger - thermisch angeschlossen wird. Dies ermöglicht eine besonders effiziente Abfuhr von im Betrieb des Halbleiterbauelements im Vertikalemitterbereich erzeugter Wärme. Dadurch wird beispielsweise ein zeitlich besonders stabiler cw-Laserbetrieb des optoelektronischen Halbleiterbauelements ermöglicht.

Gemäß zumindest einer Ausführungsform des optoelektronischen Halbleiterbauelements ist die Vertikalemitterschicht in einer Mesa des Halbleiterkörpers angeordnet. Das heißt, der Halbleiterkörper ist von einer Seite stellenweise abgetragen. Dadurch ist ein Vorsprung - die Mesa - erzeugt, in dem sich die Vertikalemitterschicht befindet. Beispielsweise ist die Mesa im Halbleiterkörper mittels eines Ätzverfahrens erzeugt. Gemäß zumindest einer Ausführungsform ist die Umgebung der Mesa zumindest stellenweise mit einem Material beschichtet, das eine besonders gute Wärmeleitfähigkeit aufweist. Das heißt, in der Umgebung der Mesa und gegebenenfalls auch auf die Seitenfläche und die Deckfläche der Mesa ist ein Material auf den Halbleiterkörper aufgebracht.

Vorzugsweise enthält das Material zumindest ein Metall oder das Material besteht aus zumindest einem Metall. Vorzugsweise findet dabei zumindest eines der folgenden Metalle Verwendung: Kupfer, Gold, Silber.

Bevorzugt ist das Material derart in der Umgebung der Mesa auf den Halbleiterkörper aufgebracht, dass die Mesa mit dem Material überformt ist. Das heißt beispielsweise, das Material ist derart auf die der Strahlungsdurchtrittsfläche abgewandten Fläche des Halbleiterkörpers aufgebracht, dass die Mesa sowie die Umgebung der Mesa mit dem Material bedeckt sind. Vorzugsweise ist diese Seite des Halbleiterkörpers dann durch das Material planarisiert. Das heißt.beispielsweise, das Material ist in solch einer Dicke aufgebracht, dass es die gleiche Höhe wie die Mesa aufweist oder die Mesa vom Material überragt wird. Dabei ist es insbesondere auch möglich, dass die Mesa vollständig vom Material umschlossen ist.

Vorzugsweise ist der Halbleiterkörper mit der der Strahlungsdurchtrittsfläche abgewandten Seite auf einen Wärmeleitkörper - beispielsweise einen Träger - befestigt.

Gemäß zumindest einer Ausführungsform weist die der Strahlungsdurchtrittsfläche abgewandte Seite des Halbleiterkörpers die Mesa mit der Vertikalemitterschicht sowie die Umgebung der Mesa auf, in der der Halbleiterkörper stellenweise abgetragen ist, so dass dort beispielsweise eine Kontaktschicht der Pumpquelle freigelegt ist.

Das heißt, der Bereich zwischen Wärmeleitkörper und Halbleiterkörper ist dann zumindest stellenweise mit dem Material befüllt. Vorzugsweise ist - abgesehen von der Mesa - der gesamte Bereich zwischen Halbleiterkörper und Wärmeleitkörper mit dem Material ausgefüllt.

Das hier beschriebene optoelektronische Halbleiterbauelement macht sich dabei unter anderem die Idee zu nutze, dass durch das Freilegen der Pumpquelle und das thermische Ankoppeln der Pumpquelle sowie der die Vertikalemitterschicht enthaltenen Mesa an den Wärmeleitkörper mittels des Materials eine besonders effiziente Kühlung von Vertikalemitterschicht und Pumpquelle ermöglicht ist. Damit tragen die Mesa sowie das die Mesa umgebende Material zu einer weiteren Verbesserung der Wärmeabfuhr im Betrieb des Halbleiterbauelements bei. Dadurch ist beispielsweise ein zeitlich besonders konstanter cw-Laserbetrieb des Halbleiterbauelements ermöglicht. Vorzugsweise weist das Material neben seiner guten thermischen Leitfähigkeit auch eine besonders gute elektrische Leitfähigkeit auf, so dass die Pumpquelle mittels des Materials auch elektrisch kontaktierbar ist.

Gemäß zumindest einer Ausführungsform des optoelektronischen Halbleiterbauelements ist das Material galvanisch in der Umgebung der Mesa abgeschieden. Dabei kann es sich bei den abgeschiedenen Schichten beispielsweise um ein Ag-, Au-, oder Ag/Au-Galvanik-Material handeln.

Darüber hinaus ist es auch möglich, dass das Material als strukturierte Wärmesenke ausgeführt ist. In die Wärmesenke können dann zum Beispiel Kühllamellen oder andere Strukturen strukturiert sein, die geeignet sind, die Oberfläche der Wärmesenke zu vergrößern.

Gemäß zumindest einer Ausführungsform des optoelektronischen Halbleiterbauelements ist die die Mesa begrenzende Seitenfläche des Halbleiterkörpers zumindest stellenweise vorgesehen, Pumpstrahlung zur Vertikalemitterschicht zu lenken. Vorzugsweise ist die Seitenfläche der Mesa geeignet, Pumpstrahlung in Richtung der Vertikalemitterschicht zu reflektieren. Das heißt, Pumpstrahlung, die von der Pumpquelle kommend die Vertikalemitterschicht durchquert ohne dort absorbiert zu werden, wird an der Seitenfläche der Mesa - also den Mesaflanken - reflektiert. Reflektierte Pumpstrahlung tritt wiederum in die Vertikalemitterschicht ein. Dadurch ist die Wahrscheinlichkeit für die Absorption von Pumpstrahlung in der Vertikalemitterschicht erhöht. Die Pumpstrahlung kann also gezielt im Mehrfachdurchgang genutzt werden.

Vorzugsweise ist die Seitenfläche der Mesa zumindest stellenweise - besonders bevorzugt vollständig - mit einem Material beschichtet, das eine Reflektivität von wenigstens 80 Prozent aufweist. Das Material weist die hohe Reflektivität vorzugsweise für den Wellenlängenbereich der Pumpstrahlung auf. Beispielsweise kann es sich bei dem Material um ein Metall oder eine Schichtfolge mit einer transparenten Passivierungsschicht sowie einer reflektierenden Metallschicht handeln.

Gemäß zumindest einer Ausführungsform des optoelektronischen Halbleiterbauelements ist die Form der Seitenfläche der Mesa so gewählt, dass die Mesaflanken gezielt Pumpstrahlung in die Vertikalemitterschicht reflektieren. Beispielsweise kann die Seitenfläche der Mesa zumindest stellenweise nach Art eines der folgenden optischen Grundelemente ausgebildet sein: Kegelstumpfoptik, Pyramidenstumpfoptik, zusammengesetzter parabolischer Konzentrator (CPC - compound parabolic concentrator), zusammengesetzter elliptischer Konzentrator (CEC - compound elliptic concentrator), zusammengesetzter hyperbolischer Konzentrator (CHC - compound hyperbolic concentrator). Das heißt, die Mesa ist zumindest stellenweise nach Art eines Kegelstumpfes, eines Pyramidenstumpfes, eines Paraboloids, eines Ellipsoids, eines Hyperboloids oder ähnlich geformt ausgebildet.

Gemäß zumindest einer Ausführungsform des optoelektronischen Halbleiterbauelements umfasst der Vertikalemitterbereich eine Bragg-Spiegelstruktur. Vorzugsweise ist die Bragg-Spiegelstruktur auf der der Pumpquelle abgewandten Seite der Vertikalemitterschicht angeordnet. Besonders bevorzugt ist die Bragg-Spiegelstruktur frei von Dotiermaterial.

Das hier beschriebene optoelektronische Halbleiterbauelement macht sich dabei unter anderem die Erkenntnis zunutze, dass durch eine undotierte Bragg-Spiegelstruktur die Absorption von freien Ladungsträgern - beispielsweise aus der Vertikalemitterschicht - gegenüber einer dotierten Bragg-Spiegelstruktur deutlich reduziert ist. Dadurch kann - verglichen mit einer dotierten Bragg-Spiegelstruktur - die Effizienz der Strahlungserzeugung in der Vertikalemitterschicht um wenigstens den Faktor zwei gesteigert werden.

Gemäß zumindest einer Ausführungsform des optoelektronischen Halbleiterbauelements umfasst das Bauelement zumindest einen weiteren Spiegel, der zusammen mit der Bragg-Spiegelstruktur einen Laser-Resonator für die in der Vertikalemitterschicht erzeugte elektromagnetische Strahlung bildet. Beispielsweise kann es sich bei dem Spiegel um einen externen Spiegel handeln, der nicht monolithisch mit dem Halbleiterkörper integriert ist. Das heißt, der Spiegel ist dann beispielsweise nicht epitaktisch mit den übrigen Bereichen des Halbleiterkörpers gewachsen. Es ist aber auch möglich, dass es sich bei dem weiteren Spiegel um eine Bragg-Spiegelstruktur handelt, die monolithisch in den Halbleiterkörper integriert ist. Die weitere Bragg-Spiegelstruktur kann dann auf der der Strahlungsdurchtrittsfläche abgewandten oder der der Strahlungsdurchtrittsfläche zugewandten Seite der Pumpquelle angeordnet sein.

Gemäß zumindest einer Ausführungsform des optoelektronischen Bauelements ist ein optisches Element im Laser-Resonator angeordnet, das sich in thermischem Kontakt mit dem Halbleiterkörper befindet. Das heißt, das optische Element nimmt zumindest eine Doppelfunktion war. Zum einen besitzt das optische Element bestimmte optische Eigenschaften und ist damit zur optischen Manipulation der im Resonator umlaufenden elektromagnetischen Strahlung vorgesehen. Zum anderen dient das optische Element als Wärmespreizer, der sich im thermischen Kontakt mit dem Halbleiterkörper befindet. Auf diese Weise trägt das optische Element zu einer weiteren Verbesserung des Wärmemanagements des Halbleiterbauelements bei. Beispielsweise ist das optische Element auf die Strahlungsdurchtrittsfläche des Halbleiterkörpers befestigt.

Gemäß zumindest einer Ausführungsform weist das optische Element zumindest eine der folgenden optischen Eigenschaften auf: frequenzselektiv, frequenzvervielfachend, reflektierend, optisch brechend. Beispielsweise kann es sich bei dem optischen Element um eines der folgenden optischen Elemente handeln: Etalon, doppelbrechendes Filter, optisch nicht linearer Kristall, Spiegel, Linse.

Gemäß zumindest einer Ausführungsform enthält oder besteht das optische Element aus einem der folgenden Materialen: Diamant, Siliziumcarbid (SiC). Das optische Element weist dabei vorzugsweise eine Dicke in Richtung der aus dem Halbleiterkörper austretenden elektromagnetischen Strahlung von zwischen 20 Mikrometer bis 70 Mikrometer, vorzugsweise von zwischen 30 Mikrometer bis 60 Mikrometer auf. Das optische Element bildet dabei beispielsweise ein Diamant- oder ein Siliziumcarbid-Etalon. Das heißt, das optische Element kann entsprechend reflektierend ausgebildet sein.

Gemäß zumindest einer Ausführungsform des optoelektronischen Halbleiterbauelements ist ein optisch nicht linearer Kristall im Resonator des Halbleiterbauelements angeordnet. Dabei kann es sich bei dem optisch nicht linearen Kristall um das optische Element handeln, das sich im thermischen Kontakt mit dem Halbleiterkörper befindet. Es ist aber auch möglich, dass es sich bei dem optisch nicht linearen Kristall um ein zusätzliches optisches Element handelt, das beabstandet vom Halbleiterkörper im Laser-Resonator angeordnet ist. Vorzugsweise ist der optisch nicht lineare Kristall zur Frequenzkonversion zumindest eines Teils der im Resonator umlaufenden elektromagnetischen Strahlung vorgesehen.

Gemäß zumindest einer Ausführungsform der Laservorrichtung umfasst der optisch nicht lineare Kristall zumindest einen der folgenden Kristalle: Lithiumtriborat z.B. LiB₃O₅ (LBO), Wismuttriborat z.B. BiB₃O₆ (BiBO), Kaliumtitanylphosphat KTiOPO₄ (KTP), magnesiumoxiddotiertes kongruentes Lithiumniobat z.B. MgO:LiNbO₃ (MgO:LN), magnesiumoxiddotiertes stöchiometrisches Lithiumniobat z.B. MgO:s-LiNbO₃ (MgO:SLN), magnesiumoxiddotiertes stöchiometrisches Lithiumtantalat z.B. MgO:LiTaO₃ (MgO:SLT), stöchiometrisches LiNbO₃ (SLN), stöchiometrisches LiTaO₃ (SLT), RTP (RbTiOPO₄), KTA (KTiOAsO₄), RTA (RbTiOAsO₄), CTA (CsTiOAsO₄).

Bevorzugt ist der optisch nicht lineare Kristall zur Frequenzverdoppelung der ihn durchtretenden Strahlung geeignet.

Abgesehen von den hier aufgeführten Kristallen zur Frequenzkonversion können aber auch andere Kristalle oder Materialien, die zur Frequenzkonversion geeignet sind, alternativ oder zusätzlich im Resonator des Lasers angeordnet sein.

Gemäß zumindest einer Ausführungsform des optoelektronischen Halbleiterbauelements weist der Laser-Resonator ein Länge von höchstens 10mm auf.

Gemäß zumindest einer Ausführungsform des optoelektronischen Halbleiterbauelements weist der Laser-Resonator ein Länge von höchstens 5mm auf.

Gemäß zumindest einer Ausführungsform des optoelektronischen Halbleiterbauelements weist der Laser-Resonator ein Länge von höchstens 0,25mm auf.

Solch kurze Resonatorlängen erlauben besonders hohe Modulationsfrequenzen von größer zehn MHz, ohne dass eine resonatorexterne Modulationsvorrichtung notwendig wäre. Solche hohe Modulationsfrequenzen erweisen sich insbesondere als besonders vorteilhaft, wenn das optoelektronische Halbleiterbauelement in einem optischen Projektionsgerät - beispielsweise einem Laserprojektor - Verwendung findet, bei dem ein projiziertes Bild mittels der so genannten "flying spot" Technik erzeugt wird.

Gemäß zumindest einer Ausführungsform des optoelektronischen Halbleiterbauelements weist die Pumpquelle eine geätzte Laserfacette auf. Die geätzte Facette bildet dann einen Spiegel für einen Laserresonator der Pumpquelle. Vorzugsweise ist die Facette als Retroreflektor ausgeführt. Solche geätzte Laserfacetten sind zum Beispiel in der Druckschrift WO2005/048423 beschrieben.

Im Folgenden wird das hier beschriebene Halbleiterbauelement anhand von Ausführungsbeispielen und den dazugehörigen Figuren näher erläutert.

In den Ausführungsbeispielen und Figuren sind gleiche oder gleich wirkende Bestandteile jeweils mit den gleichen Bezugszeichen versehen. Die dargestellten Elemente sind nicht als maßstabsgerecht anzusehen, vielmehr können einzelne Elemente zum besseren Verständnis übertrieben groß dargestellt sein.

Figur 1 zeigt eine schematische Schnittdarstellung eines hier beschriebenen optoelektronischen Halbleiterbauelements gemäß einem ersten Ausführungsbeispiel.

Figur 2 zeigt eine schematische Schnittdarstellung eines hier beschriebenen optoelektronischen Halbleiterbauelements gemäß einem zweiten Ausführungsbeispiel.

Figur 3 zeigt eine schematische Schnittdarstellung eines hier beschriebenen optoelektronischen Halbleiterbauelements gemäß einem dritten Ausführungsbeispiel.

Figur 4 zeigt eine schematische Schnittdarstellung eines hier beschriebenen optoelektronischen Halbleiterbauelements gemäß einem vierten Ausführungsbeispiel.

Figur 5 zeigt eine schematische Schnittdarstellung eines hier beschriebenen optoelektronischen Halbleiterbauelements gemäß einem fünften Ausführungsbeispiel.

Figur 6 zeigt eine schematische Schnittdarstellung eines hier beschriebenen optoelektronischen Halbleiterbauelements gemäß einem sechsten Ausführungsbeispiel.

Figur 7 zeigt eine schematische Schnittdarstellung eines hier beschriebenen optoelektronischen Halbleiterbauelements gemäß einem siebten Ausführungsbeispiel.

Figur 8 zeigt eine schematische Schnittdarstellung eines hier beschriebenen optoelektronischen Halbleiterbauelements gemäß einem achten Ausführungsbeispiel.

Die Figuren 9A, 9B, 9C, 9D, 9E, 9F zeigen schematische Aufsichten auf hier beschriebene optoelektronische Halbleiterbauelemente gemäß verschiedener Ausführungsbeispiele.

Die Figuren 10A, 10B, 10C, 10D zeigen schematische Aufsichten auf hier beschriebene optoelektronische Halbleiterbauelemente gemäß verschiedener Ausführungsbeispiele.

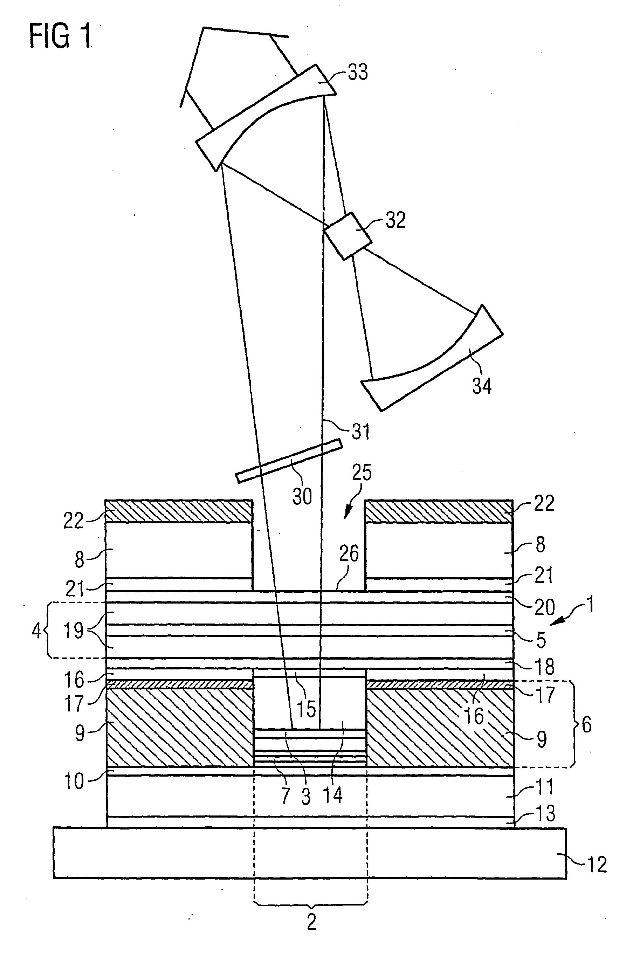

Figur 1 zeigt eine schematische Schnittdarstellung eines ersten Ausführungsbeispiels eines hier beschriebenen optoelektronischen Halbleiterbauelements.

Das Halbleiterbauelement umfasst einen Halbleiterkörper 1. Der Halbleiterkörper 1 umfasst ein Aufwachssubstrat 8. Bei dem Aufwachssubstrat 8 handelt es sich beispielsweise um ein n-dotiertes GaAs-Substrat. Das Aufwachssubstrat 8 ist vorzugsweise gedünnt. Das heißt, die Dicke des Aufwachssubstrats 8 ist vorzugsweise nach Abschluss des epitaktischen Wachstums reduziert. Dabei ist es auch möglich, dass das Aufwachssubstrat 8 vollständig entfernt ist. Vorzugsweise beträgt die Dicke des Aufwachssubstrats 8 zwischen 100 und 200 Mikrometer.

Im in Verbindung mit der Figur 1 beschriebenen Ausführungsbeispiel des Halbleiterbauelements ist in das Aufwachssubstrat 8 eine Öffnung 25 eingebracht. Die Öffnung 25 kann beispielsweise durch Ätzen erzeugt sein. In der Öffnung 25 ist die Strahlungsdurchtrittsfläche 26 des Halbleiterkörpers 1 freigelegt. Im Bereich der Öffnung 25 ist das Aufwachssubstrat 8 bevorzugt vollständig entfernt.

Dem Aufwachssubstrat 8 folgen die Pumpquelle 4 sowie der Vertikalemitterbereich 2 nach. Pumpquelle 4 und Vertikalemitterbereich 2 sind nacheinander epitaktisch auf das Aufwachssubstrat 8 abgeschieden und somit gemeinsam monolithisch in den Halbleiterkörper 1 integriert.

Der Vertikalemitterbereich 2 umfasst einen ersten Spiegel 7. Vorzugsweise handelt es sich bei dem ersten Spiegel 7 um eine Bragg-Spiegelstruktur. Alternativ kann der erste Spiegel 7 auch als Metallspiegel oder dielektrischer Spiegel oder als Kombination von zumindest zwei der drei aufgeführten Spiegelarten ausgeführt sein. Besonders bevorzugt handelt es sich bei dem ersten Spiegel 7 um eine Bragg-Spiegelstruktur, die frei von einem Dotiermaterial ist. Gegenüber einem dotierten Spiegel ist bei einer Bragg-Spiegelstruktur, die frei von Dotiermaterial ist, die Absorption freier Ladungsträger aus der Vertikalemitterschicht 3 des Vertikalemitterbereichs 2 vorteilhaft verringert.

Der erste Spiegel 7 bildet vorzugsweise einen Resonator-Spiegel für die in der Vertikalemitterschicht 3 erzeugte elektromagnetische Strahlung.

Im Betrieb des Halbleiterbauelements wird aus der Vertikalemitterschicht 3 elektromagnetische Strahlung 31, beispielsweise infrarote, sichtbare oder ultraviolette Strahlung, emittiert. Die Vertikalemitterschicht 3 enthält vorzugsweise ein III-V-Verbindungshalbleitermaterial, insbesondere InₓAl_{y}Ga_{1-x-y}N, InₓAl_{y}Ga_{1-x-y}P oder InₓAl_{y}Ga_{1-x-y}As mit 0≤x≤1, 0≤y≤1 und x+y≤1.

Weiter ist es möglich, dass die Vertikalemitterschicht 3 ein II-VI Verbindungshalbleitermaterial wie zum Beispiel ZnSe oder ZnO enthält.

Die Vertikalemitterschicht 3 ist zum Beispiel als Single-Heterostruktur, Doppel-Heterostruktur, Einfach-Quantentopfstruktur oder besonders bevorzugt als MehrfachQuantentopfstruktur ausgebildet.

Bevorzugt sind die Quantentopf-Strukturen der Vertikalemitterschicht 3 geeignet, in der Pumpquelle 4 erzeugte elektromagnetische Strahlung zu absorbieren. Das heißt, eine Absorption von Pumpstrahlung erfolgt vorzugsweise nicht in zusätzlichen Barriereschichten, die im Vertikalemitterbereich 2 angeordnet sind, sondern die Pumpstrahlung wird in den Quantentopfstrukturen der Vertikalemitterschicht 3 absorbiert und regt dort die Erzeugung von elektromagnetischer Strahlung 31 an.

In Richtung zur Strahlungsdurchtrittsfläche 26 des Halbleiterkörpers 1 hin folgt der Vertikalemitterschicht 3 im Vertikalemitterbereich 2 eine vertikale Wellenleichterschicht 14 nach. Vorzugsweise ist die Dicke der Wellenleiterschicht 14 mit einer Schichtdicke von höchsten 30 Mikrometer relativ Dick gewählt. Besonders bevorzugt beträgt die Schichtdicke der Wellenleiterschicht 14 zwischen einem halben und fünf Mikrometer. Im Ausführungsbeispiel beträgt die Schichtdicke der Wellenleiterschicht 14 circa 1,5 Mikrometer. Bevorzugt enthält die Wellenleiterschicht 14 Aluminium-Gallium-Arsenid, wobei die Aluminium-Konzentration circa sechs Prozent beträgt. Die Wellenleiterschicht 14 ist für eine Aufweitung der Pumpstrahlung, die in der Pumpquelle 4 erzeugt wird, vorgesehen. Das heißt, die Pumpstrahlung wird vorzugsweise durch das Brechungsindexprofil der Wellenleiterschicht 14 in die Vertikalemitterschicht 3 geführt, wo die Pumpstrahlung zumindest teilweise absorbiert und zur Strahlungserzeugung genutzt wird.

In Richtung zur Strahlungsdurchtrittsfläche 26 des Halbleiterkörpers 1 hin folgt der Wellenleiterschicht 14 zumindest eine Ätzstoppschicht 15 nach. Die Ätzstoppschicht 15 bildet zum einen eine selektive Ätzstoppschicht. Mittels der Ätzstoppschicht 15 ist es möglich, eine hoch dotierte Kontaktschicht 18 der Pumpquelle 4 freizulegen und auf diese Weise eine Mesa 6 herzustellen, die beispielsweise den ersten Spiegel 7, die Vertikalemitterschicht 3 sowie die Wellenleiterschicht 14 umfasst. Zum anderen dient die Ätzstoppschicht 15 zur Verbesserung der Einkopplung von Pumpstrahlung aus der Pumpquelle in die Vertikalemitterschicht 3.

In Richtung zur Strahlungsdurchtrittsfläche 26 des Halbleiterkörpers 1 hin folgt der Ätzstoppschicht 15 die hoch dotierte Kontaktschicht 18 nach. Die hoch dotierte Kontaktschicht 18 ermöglicht einen quasi-ohmschen Kontakt mit geringem Kontakt- und Serienwiderstand zur Kontaktierung der Pumpquelle 4. Vorzugsweise weist die Kontaktschicht 18 eine möglichst geringe Schichtdicke auf. Die hoch dotierte Kontaktschicht 18 ist beispielsweise mit einem p-Dotierstoff dotiert und weist eine Dotierstoffkonzentration von wenigstens 10¹⁹ cm⁻³ auf. Vorzugsweise ist die Kontaktschicht 18 im Knoten des optischen Stehwellenfeldes der in der Vertikalemitterschicht 3 erzeugten elektromagnetischen Strahlung 31 angeordnet. Dadurch werden vorteilhaft mögliche Verlustmechanismen - wie zum Beispiel die Absorption von freien Ladungsträgern in der hoch dotierten Kontaktschicht 18 - verringert.

Zur Kontaktierung der Pumpquelle 4 ist die hoch dotierte Kontaktschicht 18 vorzugsweise mittels einer transparenten Kontaktschicht 16 kontaktiert, die beispielsweise ZnO, ITO oder ein anders TCO-Material (TCO - transparent conductive oxide) enthalten kann oder aus einem dieser Materialien besteht. Des weiteren kann der Übergangsbereich vom Vertikalemitterbereich 2 zur Pumpquelle 4 weitere Schichten umfassen.

Beispielsweise können zwischen der hoch dotierten Kontaktschicht 18 und der transparenten Kontaktschicht 16 mehrere Schichten angeordnet sein, die eine hohe Aluminium-Konzentration aufweisen. Beispielweise handelt es sich bei diesen Schichten um AlₓGa₁₋ₓAs-Schichten, die lokal oxidiert sind. Die hoch aluminiumhaltigen Schichten sind vorzugsweise lateral durch Ätzen strukturiert und teilweise lokal oxidiert. In diesen lokal oxidierten AlₓO_{y}-Bereichen mit x beispielsweise größer gleich 0,98 kann eine besonders gute Wellenführung der Pumpstrahlung erreicht werden. Die Oxidation der hoch aluminiumhaltigen Schichten in Teilbereichen führt dort zu einer relativ großen Brechungsindexänderung von circa 1,4 und ermöglicht lokal eine starke optische Wellenführung des Pumplichts in vertikaler Richtung. Im Vertikalemitterbereich 2 sind die hoch aluminiumhaltigen Schichten nicht oxidiert. Der Brechungsindexunterschied ist in diesem Fall mit circa 0,13 relativ gering, so dass sich die Pumpwelle in dem Bereich der Vertikalemitterschicht 3 hin ausbreitet und dort in den Quantentopfstrukturen absorbiert werden kann.

Im Gegensatz zu den elektrisch isolierenden AlₓO_{y}-Bereichen sind in den nicht oxidierten Bereichen mittels Ätzgräben elektrisch leitende Kontakte zur Pumpquelle 4 hergestellt. Eine Kontaktierung kann mittels einer transparenten Kontaktschicht 16 oder einer Kontaktschicht erfolgen, die zum Beispiel AuZn enthält oder aus AuZn besteht.

Alternativ können die hoch aluminiumhaltigen Schichten auch entfallen. In diesem Fall ist die transparente Kontaktschicht 16 möglichst großflächig auf die hoch dotierte Kontaktschicht 18 aufgebracht. Die Kontaktschicht 16 enthält oder besteht vorzugsweise aus einem transparenten, leitfähigen Oxid (TCO) wie beispielsweise einem ZnO oder ITO. Vorzugsweise weist die Kontaktschicht 16 einen relativ zum Halbleitermaterial der Pumpquelle 4 niedrigen Brechungsindex zwischen circa 1,7 und 2,2 auf. Beispielsweise weist ZnO einen Brechungsindex von circa 1,85 und ITO einen Brechungsindex von circa 2,0 auf.

Ein solch geringer Brechungsindex und der damit verbunden hohe Brechungsindexunterschied zu den angrenzenden Halbleiterschichten ermöglicht vorteilhaft eine besonders gute Wellenführung der Pumpstrahlung in der Pumpquelle 4. Zur Verbesserung des elektrischen Kontakt zwischen Pumpquelle 4 und transparenter Kontaktschicht 16 kann zwischen der hoch dotierten Kontaktschicht 18 und der transparenten Kontaktschicht 16 eine dünne Metallschicht angeordnet sein, die vorzugsweise wenige Monolagen, bevorzugt circa eine Monolage dick ist. Diese Metallschicht enthält oder besteht vorzugsweise aus einem der folgenden Metalle: Chrom, Platin, Gold, Titan, Silber.

Alternativ zu der in Verbindung mit der Figur 1 beschriebenen Ausführungsform des optoelektronischen Halbleiterbauelements ist es auch möglich, dass auf die transparente Kontaktschicht 16 sowie die hochdotierte Kontaktschicht 18 verzichtet wird. In diesem Fall wird in selektiver Zwei-Schritt-Epitaxie eine dotierte Wellenleiterschicht mit relativ kleinem Brechungsindex auf der Pumpquelle 4 aufgebracht. Diese Schicht besteht dann beispielsweise aus Aluminium-Gallium-Arsenid mit einem Aluminium-Anteil von circa 45 Prozent und weist eine Dotieratomkonzentration von 1*10¹⁷ bis 20*10¹⁷ cm⁻³ auf. Die Schichtdicke der Wellenleiterschicht beträgt vorzugsweise circa 600 Nanometer. Auf diese Schicht mit relativ kleinem Brechungsindex ist dann eine hochdotierte Deckschicht aufgebracht, die beispielsweise aus Gallium-Arsenid mit einer Dotierstoffkonzentration von 1*10²⁰ cm⁻³ bestehen kann. Auf die Deckschicht kann eine Metallschicht aufgebracht sein, die einen ohmschen Kontakt bildet.

In Richtung zur Strahlungsdurchtrittsfläche 26 des Halbleiterkörpers 1 hin folgt der hoch dotierten Kontaktschicht 18 die Pumpquelle 4 nach. Die Pumpquelle 4 umfasst Mantelschichten 19 sowie eine Pumpschicht 5. Die Pumpquelle 4 bildet vorzugsweise einen kantenemittierenden Laser. Dazu sind die Seitenflächen des Halbleiterkörpers 1 zumindest im Bereich der Pumpquelle 4 mit einer für die Pumpstrahlung hochreflektierend.ausgebildeten - beispielsweise dielektrischen - Beschichtung versehen.

Die Pumpschicht 5 umfasst vorzugsweise einen pn-Übergang, der mittels elektrischem Pumpen zur Strahlungserzeugung vorgesehen ist. Die Mantelschichten 19 der Pumpquelle 4 sind beispielsweise aus dotiertem Aluminium-Gallium-Arsenid mit einer Aluminium-Konzentration von circa 20 Prozent gebildet und weisen eine Dicke von circa zwei Mikrometer auf.

Der Pumpquelle 4 folgt in Richtung der Strahlungsdurchtrittsfläche 26 des Halbleiterkörpers 1 eine Ätzstoppschicht 20 nach. Die Ätzstoppschicht 20 ermöglicht ein definiertes Ätzen der Öffnung 25, durch die in der Vertikalemitterschicht 3 erzeugte elektromagnetische Strahlung 31 den Halbleiterkörper 1 besonders verlustfrei verlassen kann. Ferner bildet die Ätzstoppschicht 20 vorzugsweise auch eine wellenführende Schicht mit kleinem Brechungsindex für die Pumpstrahlung der Pumpquelle 4. Zusätzlich weist die Ätzstoppschicht 20 vorzugsweise eine große Bandlücke auf. Auf diese Weise ist durch die Ätzstoppschicht 20 der Ladungsträgereinschluss in der Pumpquelle 4 verbessert. Beispielsweise ist die Ätzstoppschicht 20 durch eine circa 460 Nanometer dicke Gallium-Indium-Phosphid-Schicht gebildet.

Der Ätzstoppschicht 20 folgt im in Verbindung mit der Figur 1 beschriebenen Ausführungsbeispiel des optoelektronischen Halbleiterbauelements eine Wellenleiterschicht 21 nach. Vorzugsweise ist die Wellenleiterschicht 21 n-dotiert. Die Wellenleiterschicht 21 weist beispielsweise eine Dotierstoffkonzentration von 10¹⁷ cm⁻³ auf. Die Wellenleiterschicht 21 ist beispielsweise durch eine circa 1000 Nanometer dicke Aluminium-Gallium-Arsenid Schicht mit einem Aluminium-Anteil von 45 Prozent gebildet.

Der Wellenleiterschicht 21 ist das Aufwachssubstrat 8 nachgeordnet. Vorzugsweise ist das Aufwachssubstrat 8 gedünnt und weist eine Dicke zwischen 100 und 200 Mikrometer, vorzugsweise circa 150 Mikrometer auf. Das Aufwachssubstrat ist beispielsweise durch n-dotiertes Gallium-Arsenid mit einer Dotierstoffkonzentration von circa 2*20¹⁸ cm⁻³ gebildet.

Auf das Aufwachssubstrat 8 ist eine Kontaktmetallisierung 22 aufgebracht, die beispielsweise Gold enthalten kann oder aus Gold besteht. Die Kontaktmetallisierung 22 weist eine Schichtdicke von circa 200 Nanometer auf.

Der Halbleiterkörper 1 ist mit seiner der Strahlungsdurchtrittsfläche 26 abgewandten Seite auf einen Wärmespreizer 11 aufgebracht. Beispielsweise kann der Halbleiterkörper 1 mittels einer Lotschicht 10, die beispielsweise Zinn enthält, auf den Wärmespreizer 11 aufgebracht sein. Die Dicke der Lotschicht 10 beträgt vorzugsweise circa zwei Mikrometer. Bei dem Wärmespreizer 11 handelt es sich zum Beispiel um einen Träger, der ein gut wärmeleitendes Material wie Kupfer oder ein keramisches Material enthält.

Der Bereich zwischen transparenter Kontaktschicht 16, Mesa 6 und Wärmespreizer 11 ist vorzugsweise mit einem Material 9 ausgefüllt. Bei dem Material 9 handelt es sich um ein besonders gut wärme- und stromleitendes Material. Vorzugsweise handelt es sich bei dem Material 9 um ein Metall.

Das Material 9 ist in der Umgebung der Mesa auf den Halbleiterkörper, das heißt auf die hoch dotierte Kontaktschicht 18 und die die Mesa begrenzende Seitenflächen der Mesa aufgebracht.

Vorzugsweise handelt es sich bei dem Material 9 um Silber- oder Gold-Galvanik-Schichten. Silber und/oder Gold eignet sich dabei aufgrund seiner guten thermischen und elektrischen Leitfähigkeit. Bevorzugt ist das Material 9 mittels eines Niedertemperatur-Galvanikprozesses auf den Halbleiterkörper 1 aufgebracht.

Die vergleichsweise geringe Prozesstemperatur bei der galvanischen Abscheidung von circa zwischen 20 und 100 Grad Celsius ist insbesondere vorteilhaft, da das Halbleitermaterial, auf dem der Halbleiterkörper 1 basiert, und das Material 9 unterschiedliche thermische Ausdehnungskoeffizienten aufweisen. Dies ist beispielsweise bei einer auf Arsenid-Verbindungshalbleitern, wie zum Beispiel GaAs, basierenden Halbleiterschichtenfolgen der Fall, die einen thermischen Ausdehnungskoeffizienten von etwa 6*10⁻⁶ k⁻¹ aufweist, auf die eine Goldschicht galvanisch aufgebracht wird, die einen thermischen Ausdehnungskoeffizienten von etwa 14*10⁻⁶ K⁻¹ aufweist.

Im in Verbindung mit der Figur 1 beschriebenen Ausführungsbeispiel des optoelektronischen Halbleiterbauelements ist der Wärmespreizer 11 mit seiner dem Halbleiterkörper 1 abgewandten Seite auf einen Träger 12 montiert. Der Wärmespreizer 11 ist dabei mittels einer Lotschicht 13 mechanisch und elektrisch mit dem Träger 12 verbunden. Die Lotschicht 13 besteht beispielsweise aus Zinn und weist eine Dicke von circa zwei Mikrometer auf. Beim Träger 12 kann es sich zum Beispiel um einen Anschlussträger wie etwa eine Metallkernplatine handeln, mittels dessen die Pumpquelle 4 elektrisch kontaktierbar ist.

Der Strahlungsdurchtrittsfläche 26 des Halbleiterkörpers 1 ist ein optisches Element 30 nachgeordnet. Bei dem optischen Element 30 handelt es sich zum Beispiel um ein frequenzselektives optisches Element, das einen schmalbandigen Monomodenbetrieb des Halbleiterbauelements ermöglicht. Bei einem frequenzselektiven Element 30 handelt es sich beispielsweise um ein Etalon und/oder ein doppelbrechendes Filter.

Weiter umfasst das Halbleiterbauelement einen Faltspiegel 33, der mit dem Resonator-Spiegel 34 eine externe Kavität bildet, in der ein optisch nicht linearer Kristall 32 angeordnet ist. Der frequenzkonvertierende Kristall 32 ist vorzugsweise zur Frequenzverdoppelung der durch ihn tretende elektromagnetischen Strahlung geeignet. Der Faltspiegel 33 ist für in der Vertikalemitterschicht 3 erzeugte elektromagnetische Strahlung 31 der Fundamentalwellenlänge hoch reflektierend ausgebildet. Zumindest ein Großteil der frequenzkonvertierten Strahlung wird vom Faltspiegel 33 transmittiert.

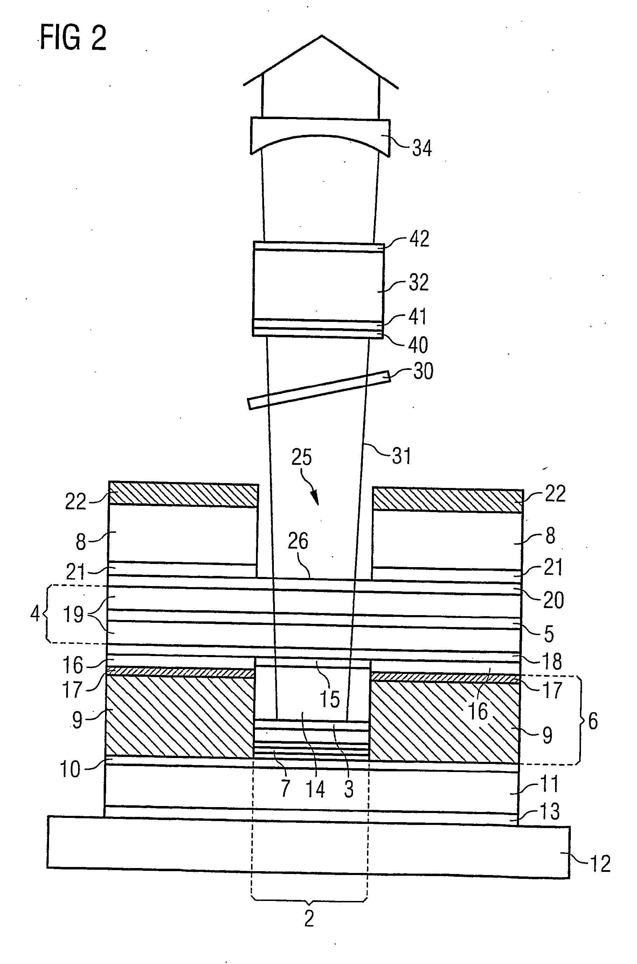

Darüber hinaus können weitere optische Elemente im Laserresonator angeordnet sein, wie beispielsweise Moden koppelnde optische Elemente, Phasen kompensierende optische Elemente, optisch abbildende Elemente wie Linsen, insbesondere Fresnel-Linsen und / oder modulationsfähige Komponenten. Diese optischen Elemente können teilweise auch direkt auf den Halbleiterkörper (1) aufgebracht sein oder monolithisch mit dem Halbleiterkörper (1) integriert sein. Figur 2 zeigt eine schematische Schnittdarstellung eines zweiten Ausführungsbeispiels eines hier beschriebenen optoelektronischen Halbleiterbauelements. Im Unterschied zum in Verbindung mit der Figur 1 beschriebenen Ausführungsbeispiel ist beim Ausführungsbeispiel der Figur 2 auf einen Faltspiegel verzichtet. Der frequenzkonvertierende Kristall 32 weist auf seiner der Strahlungsdurchtrittsfläche 26 zugewandten Strahlungsdurchtrittsfläche eine Beschichtung 41 auf, die für frequenzkonvertierte Strahlung hoch reflektierend ist. Auf die Beschichtung 41 ist eine weitere Beschichtung 40 aufgebracht, die für Strahlung 31 der Fundamentalwellenlänge entspiegelnd ausgeführt ist.

Auf der der Strahlungsdurchtrittsfläche 26 des Halbleiterkörpers 1 abgewandten Strahlungsdurchtrittsfläche des optisch nicht linearen Kristalls 32 ist eine Beschichtung 42 aufgebracht, die für Strahlung der Fundamentalwellenlänge entspiegelnd ausgeführt ist. Der Resonator-Spiegel 34 ist für Strahlung der Fundamentalwellenlänge reflektierend ausgebildet, für frequenzkonvertierte Strahlung ist der Resonator-Spiegel transmittierend.

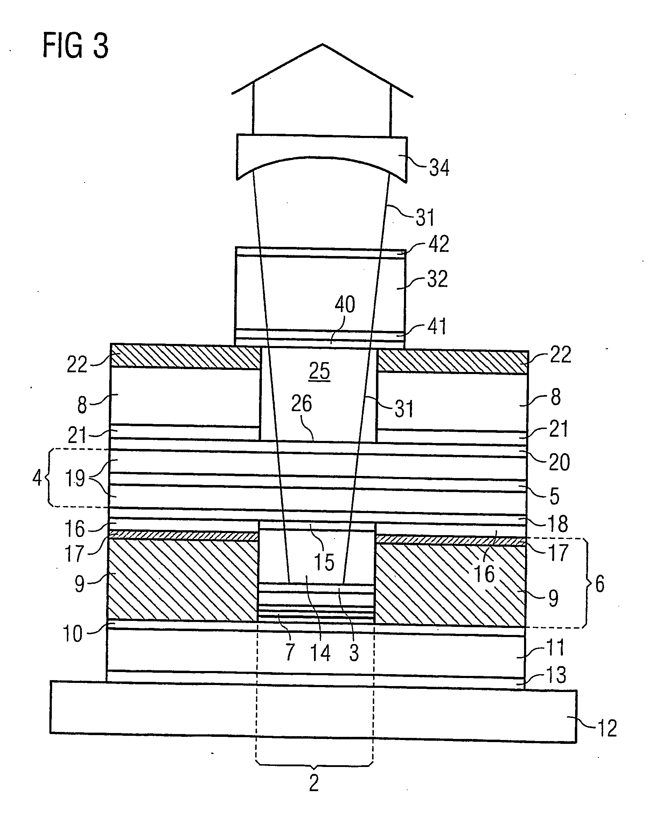

In Verbindung mit der Figur 3 ist ein drittes Ausführungsbeispiel eines hier beschriebenen optoelektronischen Halbleiterbauelements beschrieben. Im Unterschied zum in Verbindung mit der Figur 2 beschriebenen Ausführungsbeispiel ist der optisch nicht lineare Kristall 32 hier direkt auf den Halbleiterkörper 1 montiert. Auf diese Weise ist ein besonders kompaktes Lasermodul realisiert, bei dem Resonatorlängen von kleiner gleich zehn Millimeter möglich sind. Solch kurze Resonatorlängen erlauben besonders hohe Modulationsfrequenzen von größer zehn MHz, ohne dass eine resonatorexterne Modulationsvorrichtung notwendig wäre.

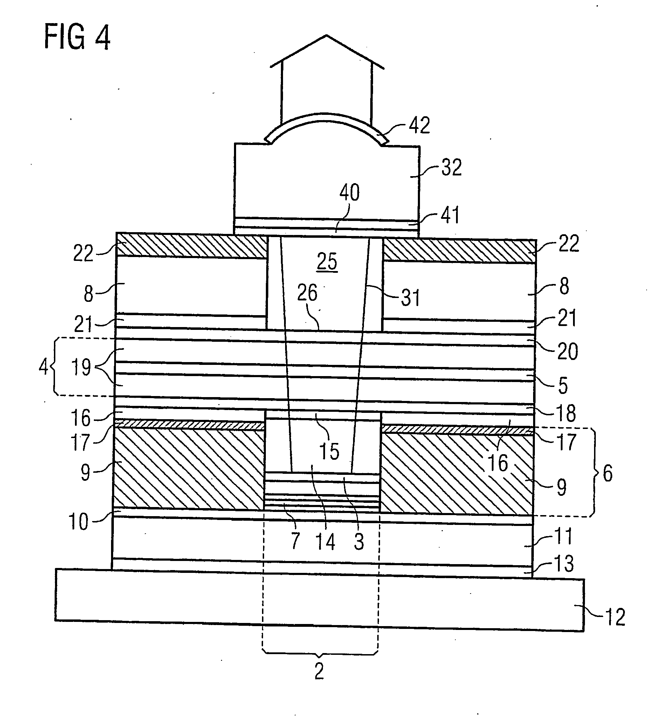

Figur 4 zeigt eine schematische Schnittdarstellung eines vierten Ausführungsbeispiels des hier beschriebenen optoelektronischen Halbleiterbauelements. Um eine weitere Miniaturisierung gegenüber dem in Verbindung mit der Figur 3 beschriebenen Ausführungsbeispiel zu ermöglichen, ist der externe Resonator-Spiegel 34 in diesem Ausführungsbeispiel durch eine gewölbte Strahlungsdurchtrittsfläche des frequenzkonvertierenden Kristall 32 ersetzt. Die dem Halbleiterkörper 1 abgewandte Strahlungsdurchtrittsfläche des optisch nicht linearen Kristalls 32 ist dazu mit einer Beschichtung 43 versehen, die für frequenzkonvertierte Strahlung entspiegelnd und für Strahlung der Fundamentalwellenlänge hoch reflektierend ist.

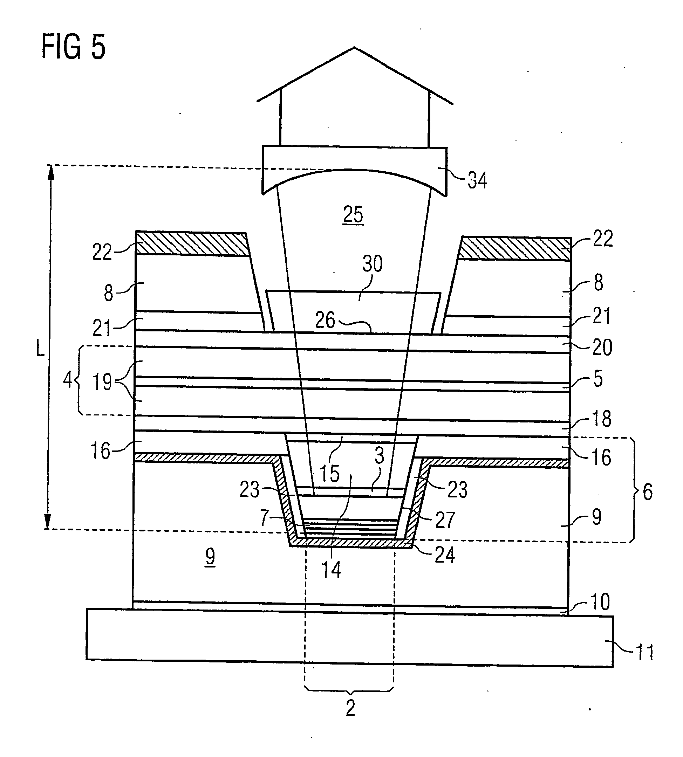

Figur 5 zeigt eine schematische Schnittdarstellung eines fünften Ausführungsbeispiels eines hier beschriebenen optoelektronischen Halbleiterbauelements. Im Unterschied zu dem in Verbindung mit den Figuren 1 bis 4 beschriebenen Ausführungsbeispielen ist in diesem Ausführungsbeispiel die Mesa 6 kegelstumpfartig ausgebildet. Das heißt, die die Mesa begrenzenden Seitenflächen 27 sind angeschrängt und schließen einen Winkel größer 0 Grad mit der oberflächennormalen beispielsweise der Vertikalemitterschicht 3 ein. Die Seitenflächen 27 sind dabei für in der Pumpquelle 4 erzeugte Pumpstrahlung reflektierend ausgebildet. Dazu sind die Seitenflächen 27 der Mesa 6 mit einer Passivierungsschicht 23 beschichtet, die beispielsweise ein Siliziumnitrid enthalten kann oder aus Siliziumnitrid besteht. Auf die Passivierungsschicht 23 ist eine für die Pumpstrahlung reflektierende Schicht 24 aufgebracht. Die reflektierende Schicht 24 weist vorzugsweise eine Reflektivität von größer gleich 80 Prozent für die Pumpstrahlung auf. Beispielsweise enthält oder besteht die reflektierende Schicht 24 aus AuZn. Die derart beschichtete Mesa 6 ist vollständig vom Material 9 eingeschlossen. Dies erlaubt eine besonders gute thermische Ankopplung des Halbleiterkörpers 1 an einen Wärmespreizer 11.

Auf die Strahlungsdurchtrittsfläche 26 des Halbleiterkörpers 1 ist ein optisches Element 30 aufgebracht, das zusätzlich als Wärmespreizer fungiert. Das optische Element 30 reduziert den thermischen Widerstand der Strahlungsdurchtrittsfläche um circa acht Kelvin pro Watt. Zusätzlich dient das optische Element 30 beispielsweise als Etalon für die in der Vertikalemitterschicht 3 erzeugte elektromagnetische Strahlung und ermöglicht dadurch eine spektrale Einschnürung der im Laser-Resonator umlaufenden Strahlung. Insgesamt ermöglicht das optische Element 30 dadurch eine möglichst temperaturunabhängige Fixierung der Laserwellenlänge. Vorzugsweise ist das optische Element 30 mittels Capillary Bonding oder einer anderen Verbindungstechnik auf der Strahlungsdurchtrittsfläche 26 befestigt.

Das optische Element 30 besteht vorzugsweise aus Siliziumcarbid oder Diamant.

Die Anordnung des optischen Elements auf der Strahlungsdurchtrittsfläche 26 erlaubt darüber hinaus eine besonders kleine Resonantorlänge L. Insbesondere sind Resonatorlängen von kleiner 10mm realisierbar.

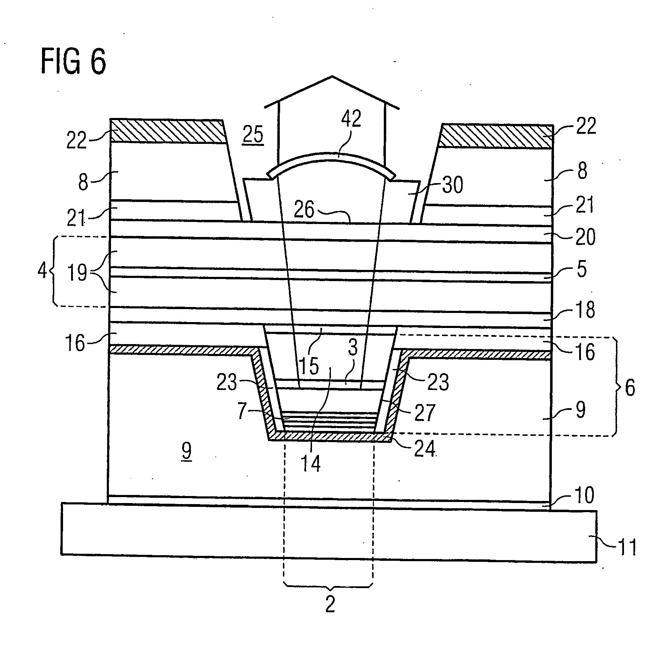

Figur 6 zeigt eine schematische Schnittdarstellung eines sechsten Ausführungsbeispiels eines hier beschriebenen optoelektronischen Halbleiterbauelements. Im Unterschied zum in Verbindung mit der Figur 5 beschriebenen Ausführungsbeispiel des Bauelements weist das optische Element hier eine gekrümmte Strahlungsdurchtrittsfläche auf, die mit einer für die elektromagnetische Strahlung der Fundamentalwellenlänge reflektierende Beschichtung 42 versehen ist. Auf diese Weise ist beispielsweise ein möglichst kompakter Laser realisiert, der zur Erzeugung von Infrarotstrahlung geeignet sein kann.

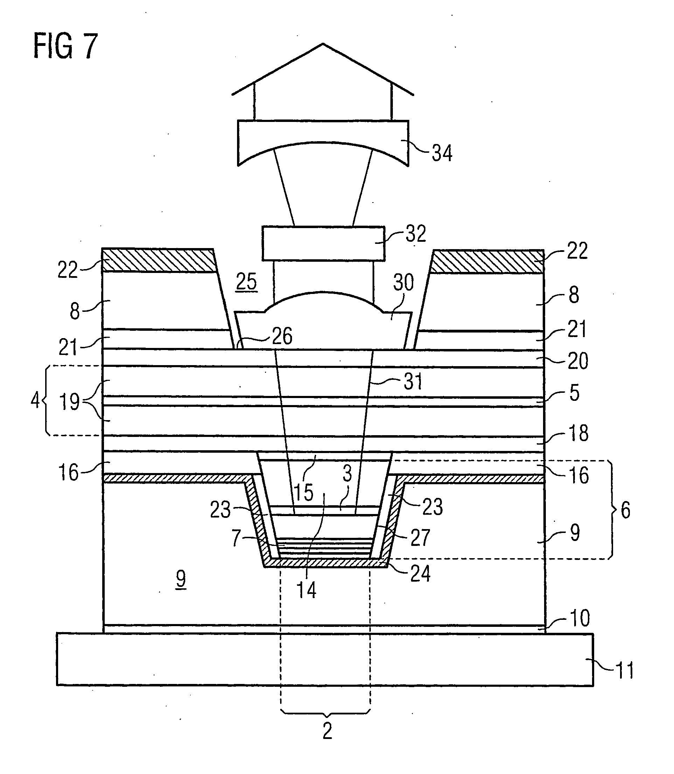

In Verbindung mit der Figur 7 ist ein siebtes Ausführungsbeispiel eines hier beschriebenen optoelektronischen Halbleiterbauelements beschrieben. In diesem Ausführungsbeispiel ist dem optischen Element 30 im Laser-Resonator ein optisch nicht linearer Kristall 32 nachgeordnet. Das optische Element 30 dient hier aufgrund der konvex von der Strahlungsdurchtrittsfläche 26 des Halbleiterkörpers 1 weggekrümmten Strahlungsdurchtrittsfläche als Mikrolinse, die zur Fokussierung der elektromagnetischen Strahlung der Fundamentalwellenlänge in den optisch nicht linearen Kristall 32 dient. Damit können besonders hohe Leistungsdichten bei der Frequenzkonversion erreicht werden. Dies ermöglicht eine effiziente Frequenzverdoppelung bei hoher Modulationsfrequenz.

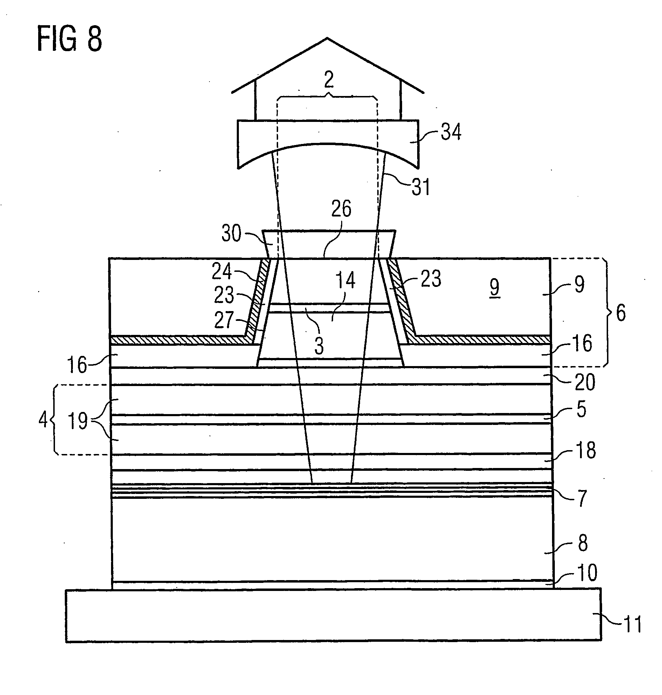

In Verbindung mit der Figur 8 ist ein achtes Ausführungsbeispiel eines hier beschriebenen optoelektronischen Halbleiterbauelements beschrieben. Im Unterschied beispielsweise zum Ausführungsbeispiel, das in Verbindung mit Figur 5 beschrieben ist, ist in diesem Ausführungsbeispiel die Vertikalemitterschicht 2 zwischen der Pumpquelle 4 und der Strahlungsdurchtrittsfläche 26 angeordnet. Das heißt, die Vertikalemitterschicht 2 folgt der Pumpquelle 4 in Abstrahlrichtung der in der Vertikalemitterschicht 3 erzeugten elektromagnetischen Strahlung 31 nach. Vorzugsweise ist die Bragg-Spiegelstruktur 7 in diesem Ausführungsbeispiel dotiert, um eine Kontaktierung der Pumpquelle 4 zu ermöglichen. Eine Anordnung des Vertikalemitterbereichs 2 zwischen der Pumpquelle 4 und der Strahlungsdurchtrittsfläche 26 ist auch bei den in Verbindung mit den Figuren 1 bis 7 beschriebenen Ausführungsbeispielen möglich.

Insgesamt eignet sich das hier beschriebene optoelektronische Halbleiterbauelement wegen der relativ kurzen Resonatorlänge L besonders gut für Laserprojektoren, bei denen eine Bildgebung mittels der Flying-Spot-Technologie erfolgt.

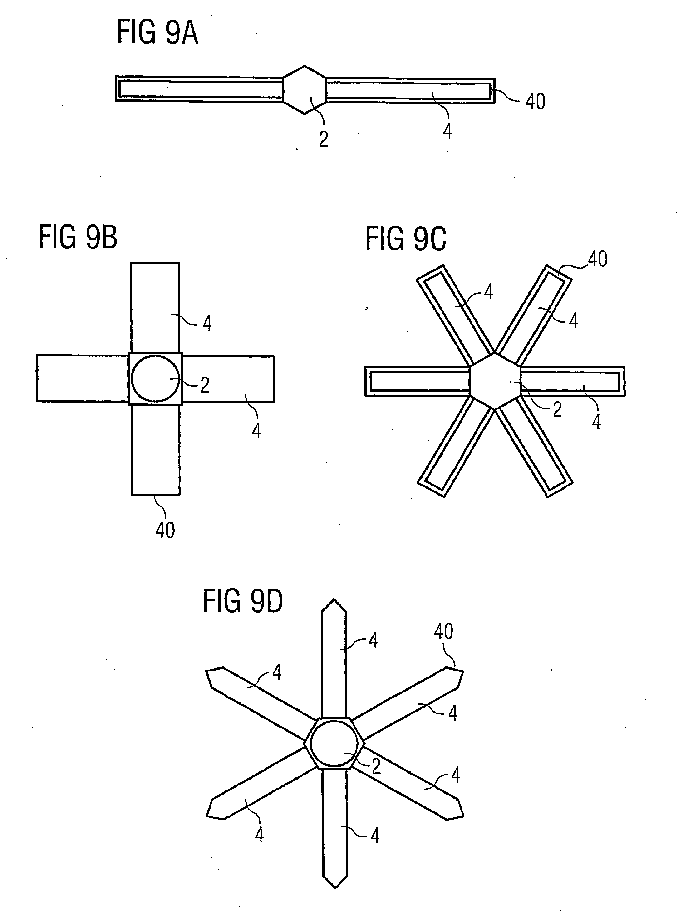

Die Figuren 9A bis 9F zeigen schematische Aufsichten auf verschiedene Ausführungsbeispiele des Halbleiterkörpers 1 des hier beschriebenen optoelektronischen Halbleiterbauelements.

Die Pumpquellen weisen Laserfacetten 40 auf, die als hoch reflektierende Spiegel ausgeführt sind. Beispielsweise können die Spiegel durch Ritzen, Berechen und Beschichten mit einer hoch reflektierenden Beschichtung erzeugt werden. Außerdem ist es möglich, dass die Facetten 40 mittels Ätzen erzeugt werden. Eine Reflektion an den Facetten kann dann mittels Totalreflektion und/oder aufgrund einer reflektierenden Beschichtung erfolgen.

Figur 9A zeigt eine Ausführungsform mit zwei sich gegenüberliegenden linearen Pumpquellen 4, die seitlich benachbart zu einem zentralen, hier sechseckig ausgeführten Vertikalemitterbereich 2 liegen.

Figur 9B illustriert ein Ausführungsbeispiel, bei dem bei einem quadratischen Vertikalemitterbereich 2 ein möglichst radial symmetrisches Strahlprofil erreicht ist. Dabei ist im Außenbereich des Vertikalemitterbereichs 2 die Vertikalemitterschicht 3 zum Beispiel durch Ionenstrahlbeschuss derart geschädigt, dass sie in diesem Bereich das Pumplicht der Pumpquellen 4 mit einer geringeren Effizienz absorbiert als im inneren, möglichst kreisrunden ausgeführten, nicht geschädigtem Bereich.

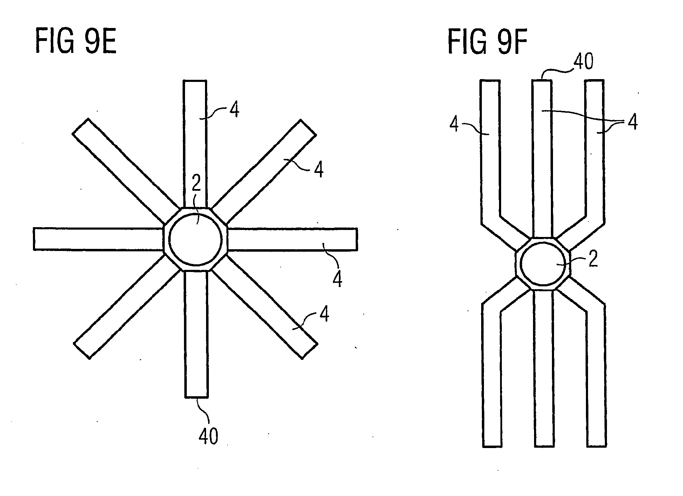

Die Figuren 9C, 9D und 9E zeigen Ausführungsformen, mit unterschiedlicher Anzahl von Pumpquellen 4.

In der in Verbindung mit der Figur 9D beschriebenen Ausführungsform sind die Laserfacetten 40 als Retroreflektoren ausgeführt, die in der Draufsicht pfeilförmig sind.

Figur 9F zeigt eine Ausführungsform mit linearen Pumpquellen 4, die abweichend von der beispielsweise in Verbindung mit den Figuren 9C bis 9E beschriebenen sternförmigen Anordnung der Pumpquellen 4 besonders platzsparend angeordnet sind.

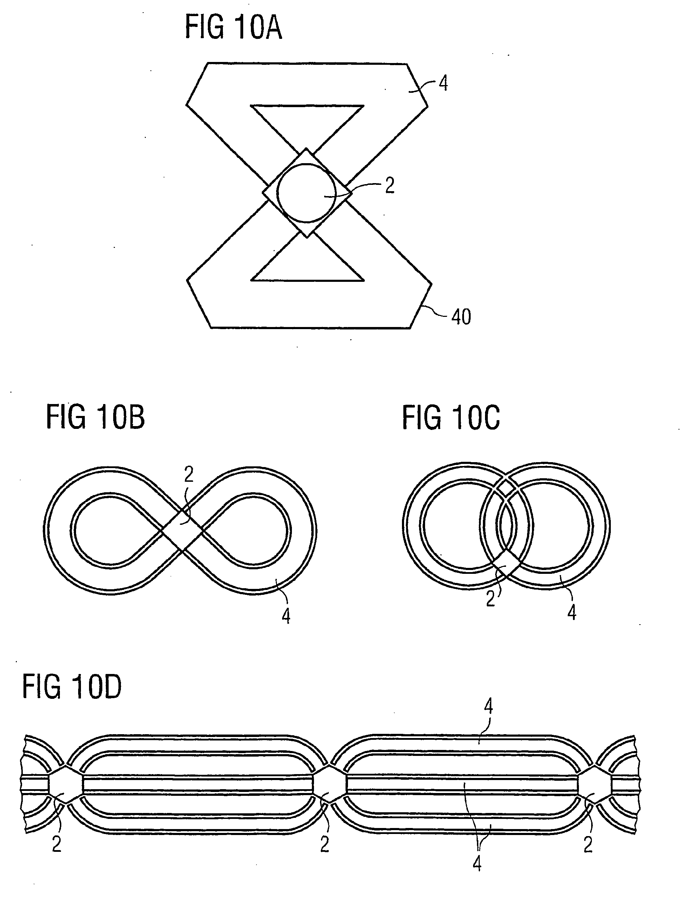

In den in Verbindung mit den Figuren 10A bis 10D beschriebenen Ausführungsbeispielen sind die Pumpquellen 4 als Ringlaser ausgeführt.

In den Figuren 10A, 10B und 10C sind Anordnungen gezeigt, bei denen der Vertikalemitterbereich 2 jeweils quadratisch ausgelegt ist. Die Pumpquelle 4 sind dabei als Ringlaser ausgeführt.

In Figur 10B ist ein Ausführungsbeispiel schematisch dargestellt, bei dem ein Ringlaser 4 vorhanden ist, der zu einer "acht" gewunden ist, in deren Kreuzungspunkt wiederum der Vertikalemitterbereich 2 angeordnet ist.

Beim in Verbindung mit der Figur 10C beschriebenen Ausführungsbeispiel sind zwei als Ringlaser ausgeführte Pumpstrahlungsquellen 4 vorgesehen sind, die sich derart überlappen, dass sie sich im Vertikalemitterbereich 2 kreuzen.

Die angegebenen, auf Wellenleitung basierenden Ringlaserstrukturen haben den Vorteil, dass auf Resonator-Endspiegel verzichtet werden kann und eventuelle Verluste an diesen Resonator-Endspiegeln entfallen.

In Figur 10D ist eine Anordnung gezeigt, bei der mehrere, in einer Reihe liegende sechseckige Vertikalemitterbereiche 2 vorgesehen sind, die von verschiedenen linearen oder auch gekrümmten Pumpquellen 4 gepumpt werden.

Die Erfindung ist nicht durch die Beschreibung anhand der Ausführungsbeispiele beschränkt. Vielmehr umfasst die Erfindung jedes neue Merkmal sowie jede Kombination von Merkmalen, was insbesondere jede Kombination von Merkmalen in den Patentansprüchen beinhaltet, auch wenn dieses Merkmal oder diese Kombination selbst nicht explizit in den Patentansprüchen oder Ausführungsbeispielen angegeben ist.

## Patentansprüche

1. Optoelektronisches Halbleiterbauelement, umfassend einen Halbleiterkörper (1) mit
- einem oberflächenemittierenden Vertikalemitterbereich (2) umfassend eine Vertikalemitterschicht (3),
- zumindest einer Pumpquelle (4), die zum optischen Pumpen der Vertikalemitterschicht (3) vorgesehen ist, und
- einer Strahlungsdurchtrittsfläche (26) durch die in der Vertikalemitterschicht erzeugte elektromagnetische Strahlung (31) den Halbleiterkörper (1) verlässt, wobei
- die Pumpquelle (4) und die Vertikalemitterschicht (3) in vertikaler Richtung voneinander beabstandet sind
- die Vertikalemitterschicht (3) in einer Mesa (6) des Halbleiterkörpers (1) angeordnet ist, und
- in der Umgebung der Mesa (6) zumindest stellenweise ein Material (9) auf den Halbleiterkörper (1) aufgebracht ist, das ein Metall enthält, **dadurch gekennzeichnet, dass**
- die Mesa (6) vom Material umformt ist, wobei das Material in solch einer Dicke aufgebracht ist, dass es die gleiche Höhe wie die Mesa (6) aufweist oder die Mesa vom Material überragt wird.

2. Optoelektronisches Halbleiterbauelement gemäß dem vorherigen Anspruch,
bei dem die Pumpquelle (4) zwischen der Vertikalemitterschicht (3) und der Strahlungsdurchtrittsfläche (26) angeordnet ist.

3. Optoelektronisches Halbleiterbauelement Anspruch 1,
bei dem die Vertikalemitterschicht (3) zwischen der Pumpquelle (4) und der Strahlungsdurchtrittsfläche (26) angeordnet ist.

4. Optoelektronisches Halbleiterbauelement gemäß Anspruch 1,
bei dem das Material (9) galvanisch in der Umgebung der Mesa (6) abgeschieden ist.

5. Optoelektronisches Halbleiterbauelement gemäß Anspruch 1 oder 4,
bei dem eine die Mesa (6) begrenzende Seitenfläche (27) für Pumpstrahlung reflektierend ausgebildet ist.

6. Optoelektronisches Halbleiterbauelement gemäß Anspruch 5,
bei dem die Seitenfläche (27) der Mesa (6) zumindest stellenweise nach Art eines der folgenden optischen Grundelemente ausgebildet ist: Kegelstumpfoptik, Pyramidenstumpfoptik, zusammengesetzter parabolischer Konzentrator, zusammengesetzter elliptischer Konzentrator, zusammengesetzter hyperbolischer Konzentrator.

7. Optoelektronisches Halbleiterbauelement gemäß einem der Ansprüche 5 oder 6,
bei dem die Seitenfläche (27) der Mesa (6) zumindest stellenweise vorgesehen ist, Pumpstrahlung zur Vertikalemitterschicht (3) zu lenken.

8. Optoelektronisches Halbleiterbauelement gemäß zumindest einem der vorherigen Ansprüche,
bei dem der Vertikalemitterbereich (3) eine Bragg-Spiegelstruktur (7) umfasst, die frei von Dotiermaterial ist.

9. Optoelektronisches Halbleiterbauelement gemäß dem vorherigen Anspruch,
bei dem die Bragg-Spiegelstruktur (7) auf der der Pumpquelle (4) abgewandten Seite der Vertikalemitterschicht (3) angeordnet ist.

10. Optoelektronisches Halbleiterbauelement gemäß zumindest einem der vorherigen Ansprüche,
bei dem das optoelektronisches Halbleiterbauelement zumindest einen Spiegel (34) umfasst, der mit der Bragg-Spiegelstruktur (7) einen Laser-Resonator für in der Vertikalemitterschicht (3) erzeugte elektromagnetische Strahlung (31) bildet und bei dem zumindest ein optisches Element (30, 32) im Laser-Resonator angeordnet ist, das sich in thermischem Kontakt mit dem Halbleiterkörper des optoelektronischen Halbleiterbauelements befindet.

11. Optoelektronisches Halbleiterbauelement gemäß dem vorherigen Anspruch,
bei dem das optische Element (30, 32) zumindest stellenweise durch eines der folgenden optischen Grundelemente gebildet ist: Etalon, doppelbrechendes Filter, optisch nichtlinearer Kristall, Spiegel, Linse.

12. Optoelektronisches Halbleiterbauelement gemäß einem der Ansprüche 10 oder 11,
bei dem der Laser-Resonator ein Länge (L) von höchstens 0,25mm aufweist.

## Claims

1. Optoelectronic semiconductor component comprising a semiconductor body (1) having
- a surface emitting vertical emitter region (2) comprising a vertical emitter layer (3),
- at least one pump source (4) provided for optically pumping the vertical emitter layer (3) and
- a radiation passage area (26) through which electromagnetic radiation (31) generated in the vertical emitter layer leaves the semiconductor body (1), wherein
- the pump source (4) and the vertical emitter layer (3) are at a distance from one another in a vertical direction,
- the vertical emitter layer (3) is arranged in a mesa (6) of the semiconductor body (1), and
- a material (9) containing a metal is applied to the semiconductor body (1) at least in places in the vicinity of the mesa (6), **characterized in that**
- the material moulds ground mesa (6), the material being applied with a thickness such that it has the same height as the mesa (6) or the material projects above the mesa.

2. Optoelectronic semiconductor component according to the preceding claim,
wherein the pump source (4) is arranged between the vertical emitter layer (3) and the radiation passage area (26).

3. Optoelectronic semiconductor component according to Claim 1,
wherein the vertical emitter layer (3) is arranged between the pump source (4) and the radiation passage area (26).

4. Optoelectronic semiconductor component according to Claim 1,
wherein the material (9) is deposited electrolytically in the vicinity of the mesa (6).

5. Optoelectronic semiconductor component according to Claim 1 or 4,
wherein a side area (27) that delimits the mesa (6) is formed in reflective fashion for pump radiation.

6. Optoelectronic semiconductor component according to Claim 5,
wherein the side area (27) of the mesa (6) is formed at least in places in the manner of one of the following optical basic elements: truncated-cone optical unit, truncated-pyramid optical unit, compound parabolic concentrator, compound elliptic concentrator, compound hyperbolic concentrator.

7. Optoelectronic semiconductor component according to either of Claims 5 and 6,
wherein the side area (27) of the mesa (6) is provided at least in places so as to direct pump radiation to the vertical emitter layer (3).

8. Optoelectronic semiconductor component according to at least one of the preceding claims,
wherein the vertical emitter region (3) comprises a Bragg mirror structure (7) that is free of doping material.

9. Optoelectronic semiconductor component according to the preceding claim,
wherein the Bragg mirror structure (7) is arranged on that side of the vertical emitter layer (3) which is remote from the pump source (4).

10. Optoelectronic semiconductor component according to at least one of the preceding claims,
wherein the optoelectronic semiconductor component comprises at least one mirror (34) which together with the Bragg mirror structure (7) forms a laser resonator for electromagnetic radiation (31) generated in the vertical emitter layer (3), and wherein at least one optical element (30, 32) which is in thermal contact with the semiconductor body of the optoelectronic semiconductor component is arranged in the laser resonator.

11. Optoelectronic semiconductor component according to the preceding claim,
wherein the optical element (30, 32) is formed at least in places by one of the following optical basic elements: etalon, birefringent filter, optically nonlinear crystal, mirror, lens.

12. Optoelectronic semiconductor component according to either of Claims 10 and 11,
wherein the laser resonator has a length (L) of at most 0.25 mm.

## Revendications

1. Elément optoélectronique semi-conducteur comprenant un corps semi-conducteur (1) doté
d'une partie verticale d'émetteur (2) émettant en surface et comprenant une couche verticale d'émetteur (3),
d'au moins une source de pompage (4) prévue pour pomper optiquement la couche verticale d'émetteur (3) et
d'une surface (26) de passage du rayonnement par laquelle le rayonnement électromagnétique (31) formé dans la couche verticale d'émetteur quitte le corps semi-conducteur (1),
la source de pompage (4) et la couche verticale d'émetteur (3) étant maintenues à distance mutuelle dans la direction verticale,
la couche verticale d'émetteur (3) étant disposée dans une mésa (6) du corps semi-conducteur (1) et
un matériau (9) qui contient un métal est appliqué sur le corps semi-conducteur (1) au moins localement dans l'environnement de la mésa (6),
**caractérisé en ce que**
la mésa (6) est formée du matériau, le matériau étant appliqué en une épaisseur telle qu'il présente la même hauteur que la mésa (6) ou que la mésa soit débordée par le matériau.

2. Elément optoélectronique semi-conducteur selon la revendication précédente, dans lequel la source de pompage (4) est disposée entre la couche verticale d'émetteur (3) et la surface (26) de passage du rayonnement.

3. Elément optoélectronique semi-conducteur selon la revendication 1, dans lequel la couche verticale d'émetteur (3) est disposée entre la source de pompage (4) et la surface (26) de passage du rayonnement.

4. Elément optoélectronique semi-conducteur selon la revendication 1, dans lequel le matériau (9) est déposé galvaniquement dans l'environnement de la mésa (6).

5. Elément optoélectronique semi-conducteur selon la revendication 1 ou 4, dans lequel une surface latérale (27) qui délimite la mésa (6) est configurée de manière à réfléchir le rayonnement de pompage.

6. Elément optoélectronique semi-conducteur selon la revendication 5, dans lequel au moins certains emplacements de la surface latérale (27) de la mésa (6) sont configurés sous la forme de l'un des éléments optiques fondamentaux suivants : optique en tronc de cône, optique en tronc de pyramide, concentrateur parabolique assemblé, concentrateur elliptique assemblé et concentrateur hyperbolique assemblé.

7. Elément optoélectronique semi-conducteur selon l'une des revendications 5 ou 6, dans lequel au moins certains emplacements de la surface latérale (27) de la mésa (6) sont prévus pour dévier le rayonnement de pompage vers la couche verticale d'émetteur (3).

8. Elément optoélectronique semi-conducteur selon au moins l'une des revendications précédentes, dans lequel la partie verticale d'émetteur (3) comporte une structure (7) en miroir de Bragg exempte de matériau de dopage.

9. Elément optoélectronique semi-conducteur selon la revendication précédente, dans lequel la structure (7) en miroir de Bragg est disposée sur le côté de la couche verticale d'émetteur (3) non tourné vers la source de pompage (4).

10. Elément optoélectronique semi-conducteur selon au moins l'une des revendications précédentes, dans lequel l'élément optoélectronique semi-conducteur comporte au moins un miroir (34) qui forme avec la structure (7) en miroir de Bragg un résonateur laser pour un rayonnement électromagnétique (31) produit dans la couche verticale d'émetteur (3) et dans lequel au moins un élément optique (30, 32) en contact thermique avec le corps semi-conducteur de l'élément optoélectronique semi-conducteur est disposé dans le résonateur laser.

11. Elément optoélectronique semi-conducteur selon la revendication précédente, dans lequel au moins certains emplacements de l'élément optique (30, 32) sont formés par l'un des éléments optiques fondamentaux suivants : étalon, filtre à double réfraction, cristal optiquement non linéaire, miroir et lentille.

12. Elément optoélectronique semi-conducteur selon l'une des revendications 10 ou 11, dans lequel le résonateur laser présente une longueur (L) d'au plus 0,25 mm.
